# EUROPEAN PATENT SPECIFICATION

(11) **EP 4 415 489 B1**
(45) Date of publication and mention of the grant of the patent: **25.03.2026**
(21) Application number: 23862297.1
(22) Date of filing: 01.09.2023
(51) Int. Cl.: H05K 1/18, H01Q 1/52, H05K 5/02, H01Q 1/24, H01H 1/58, H01H 13/02, H01H 13/14, H01H 13/20, G06F 1/16, H04M 1/02, H04M 1/23

(54) **ELECTRONIC DEVICE**
ELEKTRONISCHE VORRICHTUNG
DISPOSITIF ÉLECTRONIQUE

(30) Priority: 08.09.2022 CN 202211095621
(43) Date of publication of application: 14.08.2024
(73) Proprietor: Honor Device Co., Ltd., Shenzhen, Guangdong 518040 (CN)
(72) Inventor: YIN, Ming, Shenzhen, Guangdong 518040 (CN)
(74) Representative: Epping - Hermann - Fischer
(86) International application number: PCT/CN2023/116545
(87) International publication number: WO 2024/051603

(56) References cited:
- CN-A- 113 410 643
- CN-A- 113 410 679
- CN-A- 113 725 592
- CN-A- 114 095 098
- CN-A- 115 175 454
- CN-U- 214 045 690
- JP-A- H07 142 921
- KR-A- 20080 021 985
- US-A1- 2021 096 804

## Description

### TECHNICAL FIELD

This application relates to the field of electronic device technologies, and in particular, to an electronic device.

### BACKGROUND

A high-speed electronic component inside an existing electronic product generates a high-frequency noise when working. When a frequency of a high-frequency electromagnetic wave generated by the high-speed electronic component falls within a communication frequency band of an antenna, a coupling phenomenon occurs. In this case, interference is caused to a signal emitted by the antenna, thereby affecting performance of the antenna.

CN 114 095 098 A relates to an electronic equipment and a cavity noise suppression method. The electronic equipment can form a structure capable of suppressing transmission of noise in a cavity through a suppression device and an opening gap in a metal middle frame or a metal back plate, wherein suppression structure formed by the opening gap and the suppression device can change resonant frequency of an internal cavity of the
CN 113 410 643 A relates to a terminal device with a noise suppression structure, and the terminal device comprises an antenna, a middle frame and a first component; the middle frame comprises a metal middle plate and a metal frame, the antenna is arranged on the metal frame, the metal middle plate comprises a first surface and a second surface opposite to the first surface, the first component is arranged on the middle frame, and a first cavity is formed between the first component and the first surface.

US 2021/096804 A1 relates to an electronic device, comprising a transceiver; and a display, comprising: a display substrate a mid-support plate disposed adjacent to the display substrate, wherein the mid-support plate comprises one or more electromagnetic band gap structures formed through or disposed onto the mid-support plate; and a lower support plate disposed adjacent to the mid-support plate, wherein a space exists between the mid-support plate and the lower support plate.

### SUMMARY

The invention is set out in the appended claims.

Embodiments of this application provide an electronic device, to solve a problem that interference is caused to a signal of an antenna due to a coupling phenomenon in an electronic product, thereby affecting performance of the antenna.

To achieve the foregoing objective, the following technical solutions are used in the embodiments of this application.

An embodiment of this application provides an electronic device, including a middle frame, a display module, a circuit board, an antenna, and a connection structure. The middle frame is provided with a connection hole. The display module is located on a side of the middle frame, and is stacked with the middle frame. The circuit board is disposed on a side of the middle frame that is away from the display module. The antenna is disposed on the middle frame, the antenna includes a radiator, the radiator is provided with a feed point and a ground point, a middle point of a part that is located between the feed point and the ground point and that is on the radiator is a reference point, a region on the middle frame that is within a range from a 1/4 wavelength to a 3/4 wavelength from the reference point is a first region in a length direction of the middle frame, and the connection hole is provided in the first region. For the connection structure, an end of the connection structure is electrically connected to the circuit board, and an other end of the connection structure passes through the connection hole and is electrically connected to the display module.

In the electronic device provided in this embodiment of this application, the first region on the middle frame is provided with the connection hole, and the connection hole can allow the connection structure to pass through and connect the circuit board and the display module on two sides of the middle frame. The first region is located within the range from the 1/4 wavelength to the 3/4 wavelength from the reference point of the antenna on the middle frame, a weak region of an electromagnetic field emitted by the antenna is located in the first region, and the distribution of the electromagnetic field gradually strengthens and then gradually weakens. Therefore, strengths of the weak region of the electromagnetic field in the first region and the electromagnetic field in the nearby region are both weak. When the connection hole is provided in the first region, the efficiency of coupling between the antenna and the high-frequency noise generated by the connection structure is reduced, thereby reducing interference to a signal of the antenna and further optimizing performance of the antenna.

In some embodiments of this application, the antenna includes a GPS antenna.

In some embodiments of this application, a frequency of the antenna ranges from 700 MHz to 1 GHz.

In some embodiments of this application, the electronic device further includes a battery, the battery is disposed on the side of the middle frame that is away from the display module, and a vertical projection of the battery on the middle frame covers the first region. To be specific, the connection hole is provided in a region of the middle frame that corresponds to the battery. In this way, mounting of the circuit board and mounting of other electronic components are not affected. In some embodiments of this application, in the length direction of the middle frame, a region on the middle frame that is within a range from a 1/8 wavelength to a 5/8 wavelength from the edge of the battery that is close to the circuit board is a first sub-region, the first sub-region is located in the first region, and the connection hole is provided in the first sub-region. In this way, a range of the first region can be further reduced, thereby ensuring that the electromagnetic field distributed in the first sub-region is relatively weak.

In some embodiments of this application, the first region has a second sub-region, the connection hole is provided in the second sub-region, and in a plane parallel to the middle frame, a distance between an edge of the first region that is close to the circuit board and an edge of the battery that is close to the circuit board is L1, where L1≥25 mm. Through this distance, a position of an upper edge of the second sub-region can be accurately determined, and the distance is measured based on a geometric center of the connection hole. To be specific, when L1=25 mm and the connection hole is provided at the upper edge, the geometric center of the connection hole is located on the upper edge.

**In** some embodiments of this application, in the plane parallel to the middle frame, a distance between an edge of the second sub-region that is away from the circuit board and an edge of the battery that is away from the circuit board is L2, where L2≥15 mm. Through this distance, a position of a lower edge of the second sub-region can be accurately determined, and the distance is also measured based on the geometric center of the connection hole. To be specific, when L2=15 mm and the connection hole is provided at the lower edge, the geometric center of the connection hole is located on the lower edge.

**In** some embodiments of this application, an electromagnetic field generated by the antenna in the electronic device has a second region, a strength of the electromagnetic field distributed in the second region is less than a strength of the electromagnetic field distributed in a region other than the second region, the vertical projection of the second region on the middle frame is located in the first region, and the connection hole is provided in a vertical projection of the second region on the middle frame. The strength of the electromagnetic field distributed in the second region is less than the strength of the electromagnetic field outside the second region. Therefore, the second region is the weak region of the electromagnetic field. In this way, the connection hole is provided in the second region, and therefore the efficiency of coupling between the antenna and the high-frequency noise can be further reduced, thereby further reducing the interference to the signal of the antenna.

In some embodiments of this application, the connection hole is provided at a position at which the vertical projection of the second region on the middle frame overlaps with the vertical projection of the connection structure on the middle frame. To be specific, the connection structure can move in a width direction of the middle frame according to usage requirements. Regardless of the position at which the connection structure is disposed, the connection structure has a region whose projection overlaps with the projection of the foregoing second region on the middle frame. Therefore, the connection hole is provided at the position at which the projections overlap, so that it can be ensured that a part of the connection structure passing through the connection hole is located in the weak region of the electromagnetic field, thereby reducing the effect of coupling between the high-frequency noise signal generated by the connection structure and the electromagnetic field.

In some embodiments of this application, the middle frame includes a middle board and a frame. The connection hole is provided on the middle board, and the middle board is fixed in the frame; and the antenna is disposed on the frame. The frame includes a first part, a second part, and two third parts, the first part and the second part are distributed on two sides of the middle board in a length direction, the first part is disposed on an upper side of the middle board, and the two third parts are disposed on two sides of the middle board in a width direction. In this way, the antenna can be disposed at different positions on the frame, thereby adapting to different usage scenarios. In some embodiments of this application, the antenna is disposed on the first part, and the radiator forms a part of the frame. To be specific, a frame antenna is formed on a top portion of the frame. In some embodiments of this application, the antenna is disposed on an inner wall of the first part. In this structure, the process difficulty is reduced and the process efficiency is improved.

In some embodiments of this application, the antenna is disposed at an end of the third part that is close to the first part, and the radiator forms a part of the frame. In this way, the frame antenna can be disposed at a top end of a lateral side of the frame.

In some embodiments of this application, the antenna is disposed at an end of the third part that is close to the first part, and the antenna is disposed on an inner wall of the third part. In this structure, the process difficulty is reduced and the process efficiency is improved.

### BRIEF DESCRIPTION OF DRAWINGS

FIG. 1 is a structural diagram of an electronic device according to an embodiment of this application;
FIG. 2 is an exploded diagram of an electronic device according to an embodiment of this application;
FIG. 3 is a cross-sectional diagram of an electronic device according to an embodiment of this application;
FIG. 4 is a structural diagram of a first region on a middle board of an electronic device according to an embodiment of this application;
FIG. 5 is a structural diagram of a first sub-region on a middle board of an electronic device according to an embodiment of this application;
FIG. 6 is a structural diagram of another first region on a middle board of an electronic device according to an embodiment of this application;
FIG. 7 is a distribution effect diagram of an electromagnetic field inside an electronic device according to an embodiment of this application;
FIG. 8 is another distribution effect diagram of an electromagnetic field inside an electronic device according to an embodiment of this application;
FIG. 9 is still another distribution effect diagram of an electromagnetic field inside an electronic device according to this application;
FIG. 10 is a curve diagram of a noise current simulation result of the electronic device shown in FIG. 9;
FIG. 11 is still another distribution effect diagram of an electromagnetic field inside an electronic device according to an embodiment of this application; and
FIG. 12 is a curve diagram of a noise current simulation result of the electronic device shown in FIG. 11.

Reference numerals of the accompanying drawings: 10-Electronic device; 100-Display module; 110-Translucent cover plate; 120-Display screen; 200-Shell; 210-Rear cover; 220-Frame; 220a-First part; 220b-Second part; 221-Socket; 230-Middle board; 231-Main board region; 232-Battery region; 233-Auxiliary board region; 234-Connection hole; 235-First region; 235a-First sub-region; 235b-Second sub-region; 236-Second region; 300-Main circuit board; 400-Auxiliary circuit board; 410-USB device; 500-Battery; 600-Antenna; 700-FPC board; and 700a-Bent section.

### DESCRIPTION OF EMBODIMENTS

The following describes the technical solutions in embodiments of this application with reference to the accompanying drawings in embodiments of this application. Apparently, the described embodiments are some but not all of embodiments of this application.

The terms "first" and "second" mentioned below are merely intended for a purpose of description, and shall not be understood as an indication or implication of relative importance or implicit indication of the number of indicated technical features. Therefore, a feature limited by "first ", "second" and the like may explicitly indicate or implicitly include one or more such features.

In addition, in this application, orientation terms such as "up" and "down" are defined relative to an orientation in which a component is schematically placed in the accompanying drawings. It should be understood that these directional terms are relative concepts that are used for descriptive and clarity purposes, which may vary accordingly depending on the orientation in which the components are placed in the accompanying drawings.

In this application, unless otherwise explicitly specified or defined, the term "connection" should be understood in a broad sense. For example, the "connection" may be a fixed connection, a detachable connection or an integral connection; or may be a direct connection, or an indirect connection through an intermediary.

Embodiments of this application provide an electronic device. Specifically, the electronic device may be a portable electronic device or another type of electronic device. For example, the electronic device may be a mobile phone, a tablet personal computer (tablet personal computer), a laptop computer (laptop computer), a personal digital assistant (personal digital assistant, PDA), a personal computer, a notebook computer, a vehicle-mounted device, a wearable device, augmented reality (augmented reality, AR) glasses, an AR helmet, virtual reality (virtual reality, VR) glasses, or a VR helmet. For ease of description, the following exemplary description is made using an example in which the electronic device is a mobile phone.

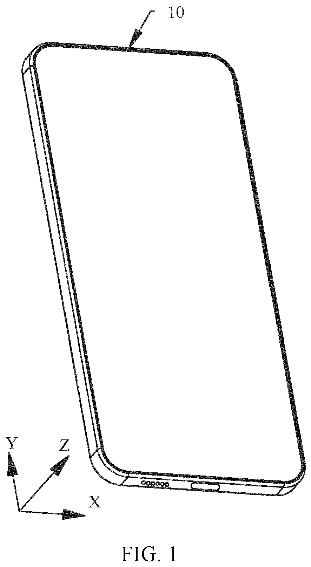

It can be learned from the above that, referring to FIG. 1, FIG. 1 is a structural diagram of an electronic device 10 according to an embodiment of this application. In this embodiment, the electronic device 10 is a mobile phone, and the electronic device 10 may be approximately in a shape of a rectangular board. On this basis, in order to facilitate the description of the following embodiments, an XYZ coordinate system is established, where a width direction of the electronic device 10 is defined as an X-axis direction, a length direction of the electronic device 10 is defined as a Y-axis direction, and a thickness direction of the electronic device 10 is defined as a Z-axis direction. It can be understood that the coordinate system of the electronic device 10 can be flexibly set according to actual needs. This application provides only one example, which cannot be considered as a special limitation on this application.

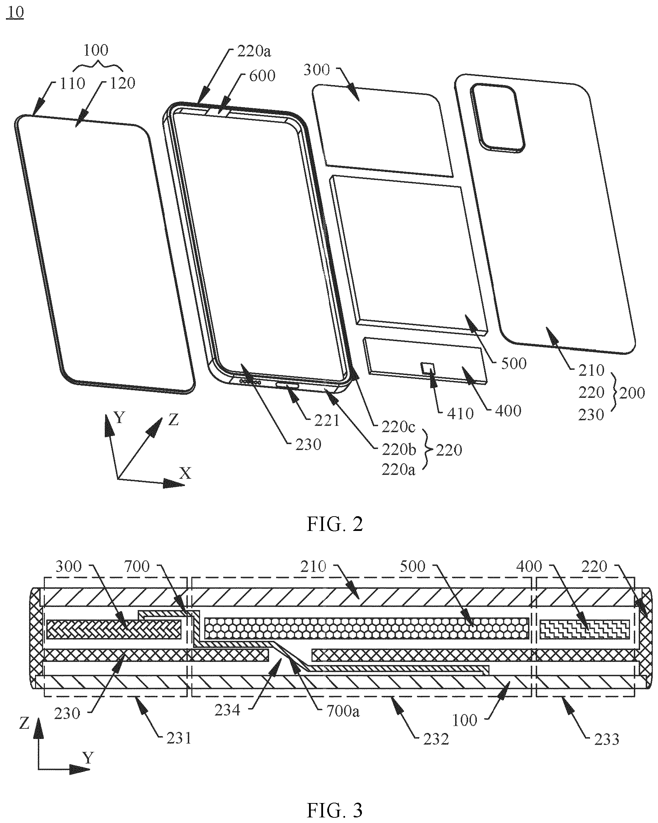

In this embodiment, referring to FIG. 2, FIG. 2 is an exploded diagram of an electronic device 10 according to an embodiment of this application. The foregoing electronic device 10 may include a display module 100, a shell 200, a main circuit board 300, an auxiliary circuit board 400, a battery 500, and an antenna 600.

The foregoing display module 100 is configured to display an image, a video, and the like. The display module 100 may include a translucent cover plate 110 and a display screen 120. Specifically, the translucent cover plate 110 and the display screen 120 are stacked and can be bonded and fixed by an optical clear adhesive. The translucent cover plate 110 may be an ordinary translucent cover plate 110 configured to protect the display screen 120 to avoid damage to the display screen 120 due to collision with an external force, and can play a dustproof role; or may be a translucent cover plate 110 with a touch function, to enable the electronic device 10 to have the touch function, thereby making it more convenient for a user to use. Therefore, this application does not specifically limit the specific material of the translucent cover plate 110.

In addition, the display screen 120 may be a flexible display screen or a rigid display screen. For example, the display screen 120 may be an organic light-emitting diode (organic light-emitting diode, OLED) display screen, an active-matrix organic light-emitting diode (active-matrix organic light-emitting diode, AMOLED) display screen, a mini organic light-emitting diode (mini organic light-emitting diode) display screen, a micro light-emitting diode (micro organic light-emitting diode) display screen, a micro organic light-emitting diode (micro organic light-emitting diode) display screen, a quantum dot light emitting diode (quantum dot light emitting diodes, QLED) display screen, or a liquid crystal display (liquid crystal display, LCD).

The foregoing shell 200 is configured to protect electronic components inside the electronic device 10. The shell 200 may include a rear cover 210 and a frame 220. The rear cover 210 is located on a side of the display screen 120 that is away from the translucent cover plate 110, and is stacked with and spaced apart from the translucent cover plate 110 and the display screen 120. The frame 220 is located between the translucent cover plate 110 and the rear cover 210. The frame 220 is fixed on the rear cover 210. For example, the frame 220 can be fixed on the rear cover 210 by bonding, snap-fit, soldering, or threaded connection. The frame 220 may alternatively be an integrally formed structure with the rear cover 210, that is, the frame 220 and the rear cover 210 are an integral structural member. The translucent cover plate 110 can be fixed on the frame 220 through adhesion, to enable the translucent cover plate 110, the rear cover 210, and the frame 220 to define an internal accommodating space of the electronic device 10. The display screen 120, the main circuit board 300, the auxiliary circuit board 400, and the battery 500 are all disposed in the internal accommodating space.

In addition, materials of the frame 220 and the rear cover 210 include but are not limited to metal, ceramic, plastic, and glass, and the materials of the frame 220 and the rear cover 210 may be the same or different. Therefore, this embodiment of this application does not specifically limit this.

In some embodiments, still referring to FIG. 2, the foregoing shell 200 may further include a middle board 230. The middle board 230 is disposed in the foregoing internal accommodating space, and the middle board 230 is located on the side of the display screen 120 that is away from the translucent cover plate 110. The middle board 230 is fixedly connected to the frame 220. For example, the middle board 230 and the frame 220 can be fixedly connected by adhesion, snap-fit, soldering, or threaded connection. The middle board 230 and the frame 220 may alternatively be an integrally formed structure, that is, the middle board 230 and the frame 220 form an integral structural member, that is, the middle frame.

The middle board 230 divides the foregoing internal accommodating space into two mutually independent spaces. A space is located between the translucent cover plate 110 and the middle board 230, and the display screen 120 is located in this space. An other space is located between the middle board 230 and the rear cover 210, and the main circuit board 300, the auxiliary circuit board 400, and the battery 500 are all disposed in this space.

The foregoing main circuit board 300 is configured to dispose electronic components of the electronic device 10 and realize electrical connection between the electronic components. For example, the electronic components may be a control chip (such as a system on chip, system on chip, SOC), a graphics processing unit (graphics processing unit, GPU), a universal flash storage (universal flash storage, UFS), a camera module, and a flash module.

The main circuit board 300 can be fixed on the middle board 230 through threaded connection, adhesion, snap-fit, or soldering. The main circuit board 300 may be a rigid printed circuit board, a flexible printed circuit, or a flexible-rigid circuit board. Therefore, this embodiment of this application does not specifically limit this.

The auxiliary circuit board 400 and the main circuit board 300 are distributed in the Y-axis direction. The auxiliary circuit board 400 can be fixed on the middle board 230, and the auxiliary circuit board 400 and the main circuit board 300 can be connected through a connector. For example, the connector may be a flexible printed circuit (flexible printed circuit, FPC), or may be a conducting wire or an enameled wire.

Specifically, the auxiliary circuit board 400 can be fixed on the middle board 230 by snap-fit, adhesion, soldering, or threaded connection. The auxiliary circuit board 400 may be a rigid printed circuit board, a flexible printed circuit, or a flexible-rigid circuit board. In addition, the auxiliary circuit board 400 and the main circuit board 300 can be made of the same material or different materials.

In addition, a universal serial bus (universal serial bus, USB) device is integrated on the auxiliary circuit board 400. The USB device 410 may be a USB type-C interface device, a USB type-A interface device, a USB type Micro-B interface device, or a USB type-B interface device. In addition, a socket 221 is provided at a position on the frame 220 corresponding to the USB device 410. Accessories such as a charger, a headset, and a data line can be electrically connected to the USB device 410 through the socket 221 to transmit power, signals, and data.

The foregoing battery 500 is fixed in the internal accommodating space of the electronic device 10. In the Y-axis direction, the battery 500 is located between the main circuit board 300 and the auxiliary circuit board 400. The battery 500 is configured to supply power to the main circuit board 300, the auxiliary circuit board 400, the display module 100, and other electronic components.

The foregoing battery 500 may include, but is not limited to, a nickel-cadmium battery, a nickel-metal hydride battery, a lithium battery, or other types of batteries including a bare cell. In addition, in the device with the battery 500 provided in this embodiment of this application, there may be one or more batteries 500. The specific quantity and arrangement of the batteries 500 can be set according to actual needs. Therefore, this embodiment of this application does not specifically limit this.

The foregoing antenna 600 is configured to receive or emit a signal for the electronic device 10. The antenna 600 may include a communication antenna, a Bluetooth antenna, a Wi-Fi antenna, a GPS antenna, and the like. In addition, the antenna 600 may be disposed on the frame 220 or may be disposed inside the shell 200.

For example, still referring to FIG. 2, the foregoing antenna 600 is a GPS antenna, and the antenna 600 is disposed on the frame 220 and is located on a top portion of the frame 220. Specifically, the frame 220 may include a first part 220a, a second part 220b, and two third parts 220c. The first part 220a is a part of the frame 220 that is disposed in the X-axis direction and disposed at a top end of the electronic device 10. The second part 220b is a bottom end of the frame 220 that is disposed in the X-axis direction and disposed at a bottom portion of the electronic device 10. The two third parts 220c are parts that are disposed in the Y-axis direction and disposed between the first part 220a and the second part 220b.

In some embodiments, the foregoing antenna 600 may be disposed on the first part 220a of the frame 220, or may be disposed on an end portion of the third part 220c of the frame 220 that is close to the first part 220a. Therefore, when the antenna 600 emits a signal, an electromagnetic field is formed inside the shell 200. Furthermore, the radiator of the antenna 600 may form a part of the frame 220, that is, form a frame antenna. Alternatively, the antenna 600 can be disposed on an inner wall of the frame 220. Therefore, this application does not specifically limit the specific arrangement form of the antenna 600. The antenna 600 shown in FIG. 2 is disposed at the first part 220a and forms the foregoing frame antenna. The following uses this structure as an example for description.

The display screen 120 and the main circuit board 300 are respectively disposed on two sides of the middle board 230, and the display screen 120 and the main circuit board 300 are connected through a connection structure. For example, the connection structure may include an FPC board 700. Therefore, referring to FIG. 3, FIG. 3 is a cross-sectional diagram of an electronic device 10 according to an embodiment of this application. The middle board 230 may be provided with a connection hole 234. The connection hole 234 is used for the FPC board 700 to pass through, so that an end of the FPC board 700 is electrically connected to the display screen 120, and an other end of the FPC board 700 is electrically connected to the main circuit board 300.

Corresponding to the vertical projections of the main circuit board 300, the battery 500, and the auxiliary circuit board 400 on the middle board 230, the middle board 230 can be divided into three parts that are a main board region 231 formed by the vertical projection of the main circuit board 300 on the middle board 230, a battery region 232 formed by the vertical projection of the battery 500 on the middle board 230, and an auxiliary board region 233 formed by the vertical projection of the auxiliary circuit board 400 on the middle board 230 respectively. To avoid affecting the mounting of the main circuit board 300 and the auxiliary circuit board 400 and the mounting of the electronic components, the foregoing connection hole 234 is generally provided in the battery region 232.

Specifically, the connection hole 234 can be provided at an edge of the battery region 232 that is close to the main board region 231, which can ensure that a bonding area for bonding and fixing between the battery 500 and the middle board 230 is maximized, thereby increasing a bonding strength of the overall structure. Alternatively, the foregoing connection hole 234 can be provided at an edge of the battery region 232 that is close to the auxiliary board region 233, so that a distance between a part of the FPC board 700 that is located in the connection hole 234 on the middle board 230 and the antenna 600 can be maximized.

However, since some electronic components on the display module 100 and the main circuit board 300 of the electronic device 10 are high-speed electronic components, the high-speed electronic components generate electromagnetic waves when working. When the electronic components generate the electromagnetic waves, the electromagnetic waves propagate through the FPC board 700 that connects the main circuit board 300 to the display screen 120. When a frequency of the electromagnetic wave emitted by the FPC board 700 falls within a communication frequency band of the antenna 600, coupling occurs inside the shell 200. **In** this way, interference is caused to the signal of the antenna 600, that is, the sensitivity of the antenna 600 to signal receiving is affected, which further causes the performance of the antenna 600 to deteriorate.

Specifically, for a part of the FPC board 700 that passes through the connection hole 234 (hereinafter referred to as a bent section 700a), since a structure of the bent section 700a needs to be bent in a Z direction, the structure of the bent section 700a is unevenly distributed. As a result, the electromagnetic wave emitted by the bent section 700a is also unevenly distributed, and consequently a coupling phenomenon is prone to occur between the electromagnetic wave emitted by the bent section 700a and the electromagnetic field generated by the antenna 600.

In addition, through noise current simulation, it can be seen that strengths of the electromagnetic field generated by the antenna 600 are different in various regions inside the electronic device 10, and the foregoing two positions at which the connection hole 234 is provided are both in regions in which the strengths of the electromagnetic field generated by the antenna 600 are strong. Therefore, coupling is prone to occur between the electromagnetic wave emitted by the FPC board 700 and the electromagnetic field generated by the antenna 600, thereby affecting the performance of the antenna 600.

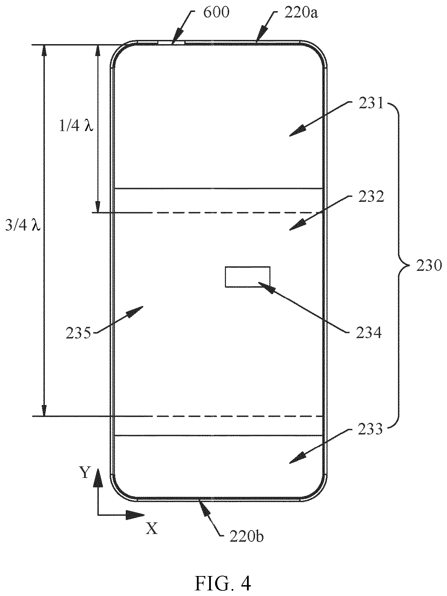

Based on this, referring to FIG. 4, FIG. 4 is a structural diagram of a first region 235 on a middle board 230 of an electronic device 10 according to an embodiment of this application. The middle board 230 can be applied in the foregoing electronic device 10, and an example in which the foregoing antenna 600 is a GPS antenna is used for detailed description.

Specifically, the foregoing middle board 230 is fixed in the frame 220, and the antenna 600 is disposed on the first part 220a of the frame 220, that is, the antenna 600 is disposed at a top end of the electronic device 10. The antenna 600 includes a radiator, the radiator is provided with a feed point and a ground point, and a middle point of a connecting line between the feed point and the ground point on the radiator is a reference point. A first region 235 is formed on the middle board 230, and the first region 235 is a region that is within a range from a 1/4 wavelength to a 3/4 wavelength from the reference point in a Y-axis direction. The connection hole 234 is provided in the first region 235. It should be noted that the wavelength is a wavelength of the antenna 600.

It can be seen from the foregoing noise current simulation that the weak region of the electromagnetic field generated by the antenna 600 is located in the first region 235, and the distribution of the electromagnetic field gradually strengthens and then gradually weakens. Therefore, the weak region of the electromagnetic field located in the first region 235 and the electromagnetic field in the surrounding region are relatively weak, that is, the overall strength of the electromagnetic field distributed in the first region 235 is weak. **In** this way, the foregoing connection hole 234 is provided in the first region 235, and the bent section 700a of the FPC board 700 can be located in a region in which the strength of the electromagnetic field is weak, to weaken the effect of coupling between the electromagnetic wave emitted by the bent section 700a of the FPC board 700 and the electromagnetic field generated by the antenna 600, thereby reducing interference to the antenna 600 to ensure the performance of the antenna 600.

It should be noted that the antenna 600 shown in FIG. 4 is a frame antenna. The specific position of the foregoing reference point is not shown in the figure. However, the first region is defined based on the foregoing reference point and cannot be defined based on the inner wall of the frame shown in the figure.

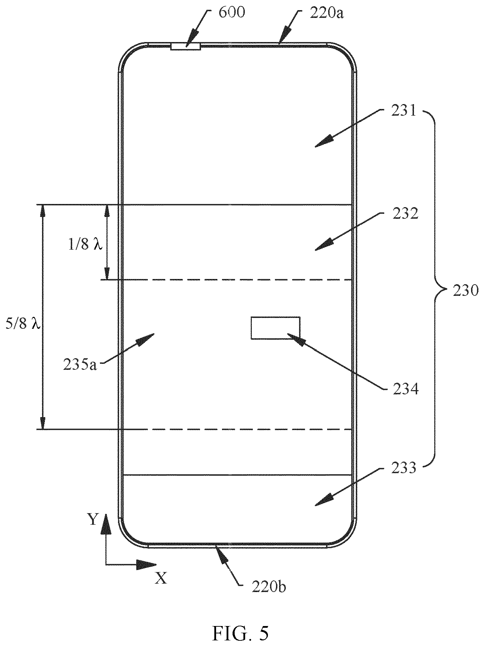

In addition, the connection hole 234 is generally provided in a vertical projection region of the battery 500 on the middle board 230, that is, in the foregoing battery region 232. Therefore, referring to FIG. 5, FIG. 5 is a structural diagram of a first sub-region 235a on a middle board 230 of an electronic device 10 according to an embodiment of this application. The first sub-region 235a may be a region ranging from a 1/8 wavelength to a 5/8 wavelength from an upper edge of the battery region 232 (that is, an edge at which the battery region 232 and the main board region 231 are connected), the first sub-region 235a is located in the first region 235, and the connection hole 234 is provided in the first sub-region 235a. In this way, the connection hole 234 is located in the battery region 232, which does not affect the mounting of the main circuit board 300 and the auxiliary circuit board 400 and the mounting of the electronic components on the main circuit board 300. In addition, it can also be ensured that the weak region of the electromagnetic field is located in the battery region 232.

Furthermore, the foregoing antenna 600 may alternatively be an antenna with a frequency ranging from 700 MHz to 1 GHz. Through the foregoing structure, the interference caused to the antenna 600 can also be reduced. Therefore, this embodiment of this application does not specifically limit the specific type of the antenna 600.

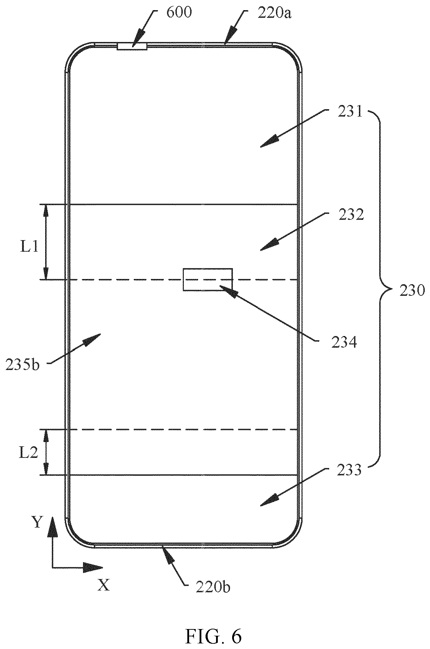

In some embodiments, referring to FIG. 6, FIG. 6 is a structural diagram of a second sub-region 235b on a middle board 230 of an electronic device 10 according to an embodiment of this application. The foregoing antenna 600 is a GPS antenna 600, and the GPS antenna 600 has a working frequency of 1.5754 GHz, and corresponds to a 1/4 wavelength of approximately 4.76 cm. Therefore, a second sub-region 235b may be further formed in the foregoing first region 235. Except for a length of the main board region 231 in the Y-axis direction, a distance between an upper edge of the second sub-region 235b (that is, an edge close to the main board region 231) and an upper edge of the battery region 232 is L1, where L1≥25 mm. In addition, a distance between a lower edge of the second sub-region 235b (an edge close to the auxiliary board region 233) and a lower edge of the battery region 232 (that is, an edge at which the battery region 232 and the auxiliary board region 233 are connected) is L2, where L2≥15 mm.

In this way, the second sub-region 235b is formed within a range from at least 25 mm from the upper edge of the battery region 232 to at least 15 mm from the lower edge of the battery region 232, and the connection hole 234 is provided in the second sub-region 235b. To be specific, the second sub-region 235b is formed in a range in which L1=25 mm and L2=15 mm, and this size forms a maximum range of the second sub-region 235b. In addition, L1 may be 26 mm, 27 mm, 28 mm, 29 mm, 30 mm, 31 mm, 32 mm, 33 mm, 34 mm, 35 mm, 38 mm, 40 mm, and the like; and L2 may be 16 mm, 17 mm, 18 mm, 19 mm, 20 mm, 22 mm, 25 mm, and the like. The limited range of the second sub-region 235b may be formed by any combination of the above. Therefore, this application does not specifically limit this.

It should be noted that each of the foregoing distances L1 and L2 is a distance from a geometric center of the connection hole 234 to an edge of the battery region 232. For example, when the connection hole 234 is a rectangular hole, L1 and L2 are distances from an intersecting point of two diagonals of the rectangular hole to edges of the battery region 232. When the connection hole 234 is a circular hole, L1 and L2 are distances from a center of the circular hole to the edges of the battery region 232.

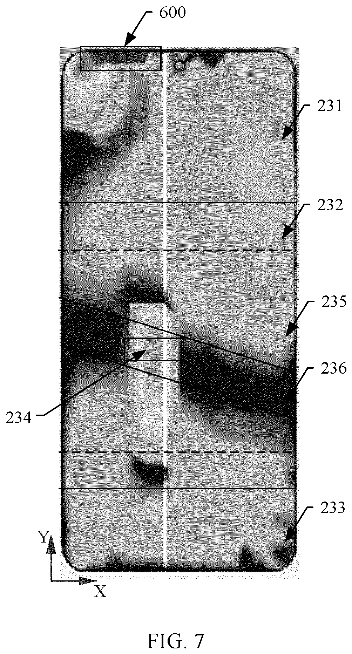

On this basis, referring to FIG. 7, FIG. 7 is a distribution effect diagram of an electromagnetic field inside an electronic device 10 according to an embodiment of this application. The electromagnetic field generated by the foregoing antenna 600 inside the electronic device 10 has a second region 236. A magnetic field strength of the second region 236 is less than a magnetic field strength of a region other than the second region 236, that is, the second region 236 is the weak region of the electromagnetic field. In addition, a vertical projection of the second region 236 on the middle board 230 is located in the first region 235, and the connection hole 234 is provided in the vertical projection of the second region 236 on the middle board 230.

Specifically, in a propagation process of the electromagnetic field emitted by the antenna 600 inside the electronic device 10, at least a part of the electromagnetic field is reflected by the inner wall of the shell 200 of the electronic device 10, thereby forming a standing wave inside the electronic device 10, and a position of a wave node of the standing wave is a region in which the strength of the electromagnetic field is weakest, that is, the foregoing second region 236.

In this way, the connection hole 234 is provided in the foregoing second region 236, and the connection hole 234 can be located in the region in which the strength of the electromagnetic field is weakest, thereby further reducing the effect of coupling between the bent section 700a of the FPC board 700 and the electromagnetic field of the antenna 600, so that the interference to the antenna 600 can be further reduced.

In some embodiments, still referring to FIG. 7, the antenna 600 may be disposed at different positions on the first part 220a of the frame 220 in the X-axis direction. In this way, the position of the second region 236 is changed. Therefore, the connection hole 234 can be provided at a position at which the vertical projection of the second region 236 on the middle board 230 overlaps with the vertical projection of the FPC board 700 on the middle board 230.

For example, still referring to FIG. 7, when the antenna 600 is disposed at a position shown in the figure (an upper left corner of an XY plane), the second region 236 has an extending direction forming an angle with the X-axis direction, that is, gradually extends downward from left to right in the figure. The connection hole 234 may be provided in the overlapping region of the vertical projections of the second region 236 shown in the figure and the FPC board 700 on the middle board 230 (that is, in the XY plane).

It should be noted that since the second region 236 extends obliquely in the XY plane, when the disposition position of the FPC board 700 moves in the X-axis direction, the position of the connection hole 234 needs to move in the extending direction of the second region 236, that is, the connection hole 234 moves in the Y-axis direction while moving in the X-axis direction.

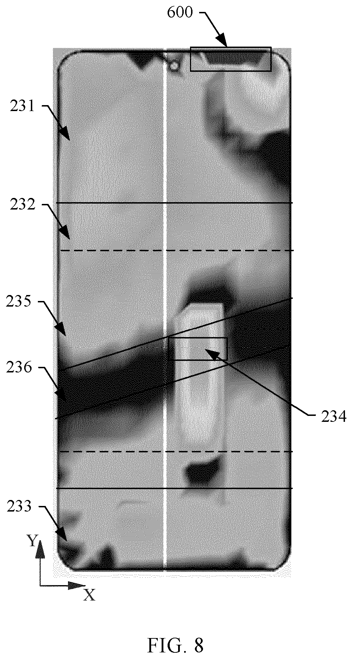

In some other embodiments, referring to FIG. 8, FIG. 8 is another distribution effect diagram of an electromagnetic field inside an electronic device 10 according to an embodiment of this application. The foregoing antenna 600 can alternatively be disposed at a position shown in the figure (an upper right corner of the XY plane). In this case, the second region 236 has an extending direction opposite to a direction shown in the figure, that is, gradually extends downward from right to left. Alternatively, the foregoing antenna 600 may be disposed in a middle position on the first part 220a of the frame 220. In this case, the second region 236 can extend in the X-axis direction.

A method for detecting the position of the connection hole 234 is described in detail below.

In a practical problem, coupling is formed between the electromagnetic wave emitted by the bent section 700a of the FPC board 700 and the electromagnetic field generated by the antenna 600, thereby causing interference to the antenna 600. Based on the analysis of the reciprocity theorem, it can be seen that in the practical problem, a strength of the electromagnetic field received by the antenna 600 when the FPC board 700 is excited is the same as a strength of the electromagnetic field received by the FPC board 700 when the antenna 600 is excited. Therefore, in the production process, by exciting a port of a sensitive antenna 600 (for example, the GPS antenna 600) and then observing the strength of the electromagnetic field in each region, the strengths of interference caused to the antenna at different positions can be determined.

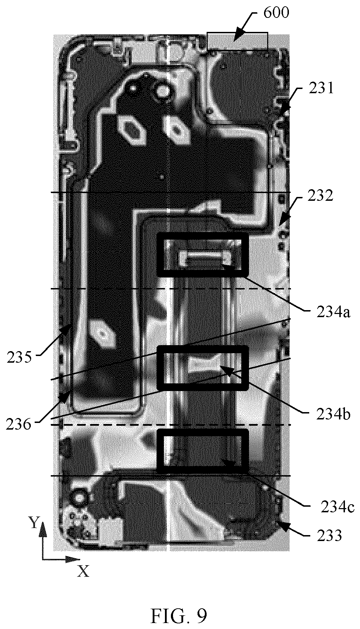

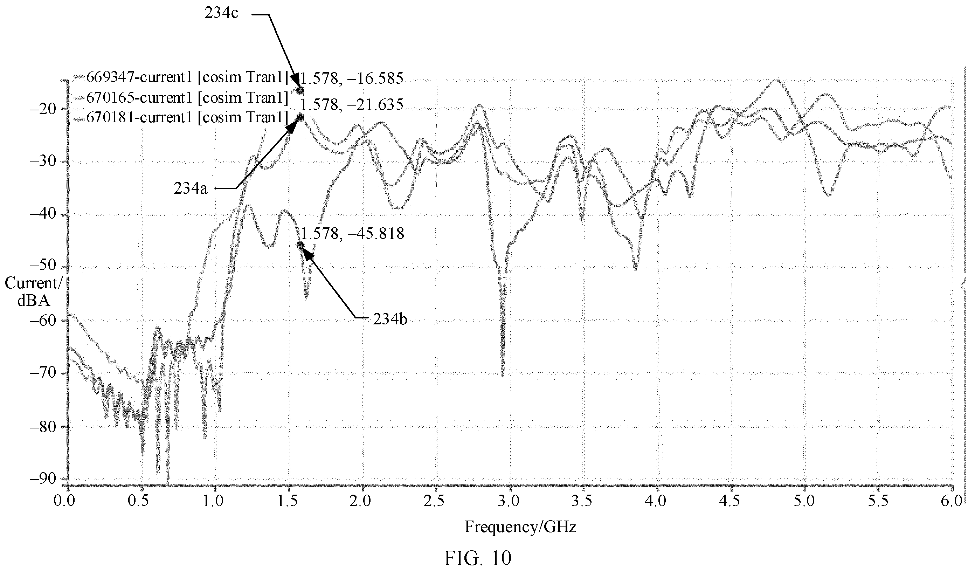

In some examples, referring to FIG. 9 and FIG. 10, FIG. 9 is still another distribution effect diagram of an electromagnetic field inside an electronic device 10 according to an embodiment of this application, and FIG. 10 is a curve diagram of a noise current simulation result of the electronic device 10 shown in FIG. 9. In FIG. 9, the antenna 600 is disposed at the upper right corner of the electronic device 10, and FIG. 9 further shows positions at which three connection holes 234 are provided, which are a first position 234a, a second position 234b, and a third position 234c in the Y-axis direction respectively. The first position 234a is located on the upper side of the first region 235, the second position 234b is located in the first region 235, and is located at a position at which the vertical projections of the second region 236 and the FPC board 700 on the middle board 230 overlap with each other, and the third position 234c is located on the lower side of the first region 235. The noise current simulation result of the electronic device is shown in Table 1.

**Table 1**

| Simulation data | First position 234a | Second position 234b | Third position 234c |
|---|---|---|---|
| Noise current simulation | -21.64 dBA | -45.8 dBA | -16.6 dBA |

It can be seen from Table 1 that a noise current at the second position 234b is lowest, that is, the electromagnetic compatibility at the second position 234b is optimal. It can be seen that the connection hole 234 is provided at the position at which the electromagnetic field distribution is weakest, which can obtain the best electromagnetic compatibility. Therefore, interference to the antenna 600 is reduced, to improve the sensitivity of the antenna 600.

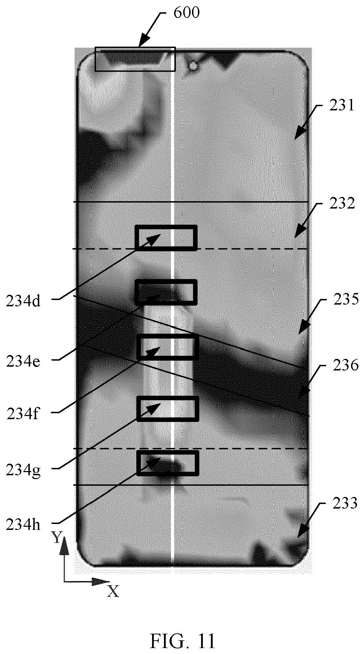

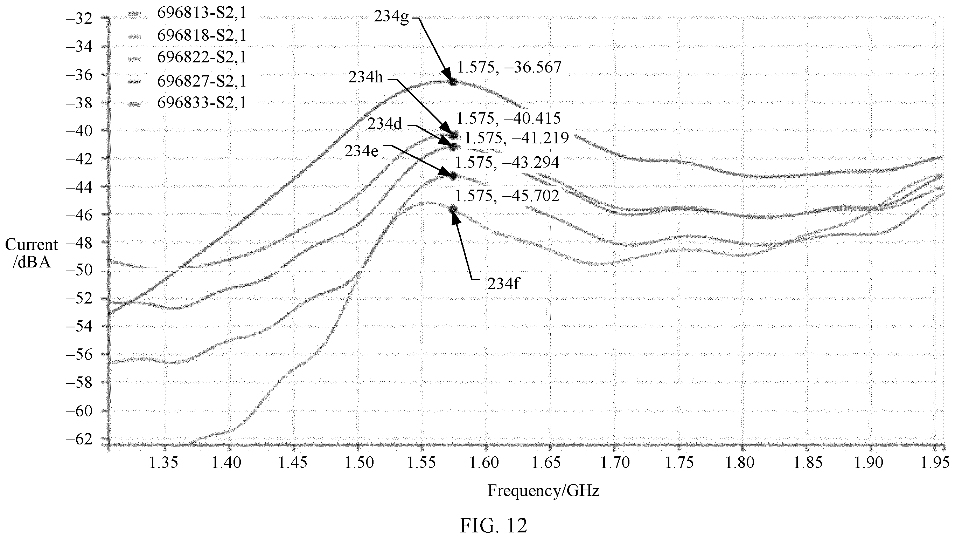

In another example, referring to FIG. 11 and FIG. 12, FIG. 11 is still another distribution effect diagram of an electromagnetic field inside an electronic device 10 according to an embodiment of this application, and FIG. 12 is a curve diagram of a noise current simulation result of the electronic device 10 shown in FIG. 11. In FIG. 11, the antenna 600 is disposed at the upper left corner of the electronic device 10. The edge at which the battery region 232 and the main board region 231 are connected is used as a reference edge, and magnitudes of noise currents at five positions that are 20 mm, 35 mm, 50 mm, 65 mm, and 80 mm away from the reference edge (in FIG. 11, respectively represented as a first position 234d, a second position 234e, a third position 234f, a fourth position 234g, and a fifth position 234h) are respectively detected. An original position at which the connection hole 234 is provided in the related art is 20 mm away from the reference edge. Compared with the original position, other positions are moved downward by 15 mm, 30 mm, 45 mm, and 60 mm respectively, and a position that is 50 mm away from the reference edge (moved downward by 30 mm compared with the original position) is in the foregoing second region 236, that is, in the weak region of the electromagnetic field. The noise current simulation result is shown in Table 2.

**Table 2**

| Detection position | Distance of downward movement compared with the original position | Distance from the reference edge | Magnitude of a noise current |
|---|---|---|---|
| First position 234d | 0 | 20 | -41.22 |
| Second position 234e | 15 | 35 | -43.3 |
| Third position 234f | 30 | 50 | -45.7 |
| Fourth position 234g | 45 | 65 | -36.57 |
| Fifth position 234h | 60 | 80 | -40.42 |

It can be seen from Table 2 that the noise current is smallest at the position of the weak region of the electromagnetic field, that is, 50 mm away from the reference edge (the third position 234f), so that the best electromagnetic compatibility can be obtained. The connection hole 234 is provided at this position, so that the interference to the antenna 600 caused by the uneven electromagnetic wave emitted by the bent section 700a of the FPC board 700 can be minimized, thereby improving the sensitivity of the antenna 600.

Based on this, it can be determined that the foregoing connection hole 234 is provided in the second region 236, that is, the weak region of the electromagnetic field, to reduce the effect of coupling between the electromagnetic wave emitted by the bent section 700a of the FPC board 700 and the electromagnetic field generated by the antenna 600, thereby reducing the interference to the antenna 600 to improve the performance of the antenna 600.

In the descriptions of this specification, the described specific features, structures, materials, or characteristics may be combined in a proper manner in any one or more of the embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device (10), comprising:
an antenna (600),
a middle frame (220), the middle frame (220) comprising a frame (220) and a middle board (230), the middle board (230) being fixed in the frame (220), and the middle board (230) being provided with a connection hole (234), wherein the middle board (230) has a first region (235), the connection hole (234) is located in the first region (235), and the first region (235) is a region on the middle board (230) that is within a range from a 1/4 wavelength to a 3/4 wavelength from the antenna (600), wherein the wavelength is the wavelength of the antenna (600);
a display module (100), the display module (100) being located on a side of the middle board (230), and being stacked with the middle board (230);
a circuit board, the circuit board being located on a side of the middle board (230) that is away from the display module (100);
the antenna (600) being disposed on the middle frame (220); and
a connection structure, an end of the connection structure being electrically connected to the circuit board, and an other end of the connection structure passing through the connection hole (234) and being electrically connected to the display module (100), wherein
a vertical projection region of the connection hole (234) on the middle board (230) is located close to a wave node of a standing wave of the antenna (600), and the wave node is located in the first region (235).

2. The electronic device (10) according to claim 1, wherein the antenna (600) comprises a radiator, the radiator is provided with a feed point and a ground point, a reference point is comprised between the feed point and the ground point, and a region on the middle board (230) that is within a range from a 1/4 wavelength to a 3/4 wavelength from the reference point is the first region (235).

3. The electronic device (10) according to claim 1 or 2, wherein the antenna (600) comprises a GPS antenna (600).

4. The electronic device (10) according to any one of claims 1 to 3, wherein an electromagnetic field generated by the antenna (600) in the electronic device (10) has a weak region, the middle board (230) has a second region (236), the second region (236) is located in the weak region, and the connection hole (234) is located in the second region (236).

5. The electronic device (10) according to claim 4, wherein a vertical projection region of the connection structure on the middle board (230) has an overlapping region with the second region (236), and the connection hole (234) is located in the overlapping region.

6. The electronic device (10) according to any one of claims 1 to 5, wherein the electronic device (10) further comprises:
a battery (500), the battery (500) being located on the side of the middle board (230) that is away from the display module, (100), and the connection hole (234) being located in a vertical projection region of the battery (500) on the middle board (230).

7. The electronic device (10) according to claim 6, wherein the vertical projection region of the battery (500) on the middle board (230) has no overlapping region with a vertical projection region of the circuit board on the middle board (230).

8. The electronic device (10) according to any one of claims 1 to 7, wherein the end of the connection structure is electrically connected to a side of the circuit board that is away from the middle board (230).

9. The electronic device (10) according to claim 6 or 7, wherein in a length direction of the middle board (230), the battery (500) is provided with an edge close to the circuit board, a region on the middle board (230) that is within a range from a 1/8 wavelength to a 5/8 wavelength from the edge is a first sub-region (235a), and the connection hole (234) is located in the first sub-region (235a).

10. The electronic device (10) according to claim 6 or 7, wherein the first region (235) has a second sub-region (235b), the connection hole (234) is located in the second sub-region (235b), and in a plane parallel to the middle board (230), a distance between an edge of the second sub-region (235b) that is close to the circuit board and an edge of the battery (500) that is close to the circuit board is L1, wherein L1≥25 mm.

11. The electronic device (10) according to claim 10, wherein in the plane parallel to the middle board (230), a distance between an edge of the second sub-region (235b) that is away from the circuit board and an edge of the battery (500) that is away from the circuit board is L2, wherein L2 15 mm.

12. The electronic device (10) according to any one of claims 1 to 11, wherein the antenna (600) is located on the frame (220), the frame (220) comprises a first part (220a), a second part (220b), and two third parts, the first part (220a) and the second part (220b) are distributed on two sides of the middle board (230) in a length direction, the first part (220a) is disposed on an upper side of the middle board (230), and the two third parts are disposed on two sides of the middle board (230) in a width direction.

13. The electronic device (10) according to claim 12, when dependent on claim 2, wherein the antenna (600) is located on the first part (220a), and the radiator forms a part of the frame (220).

14. The electronic device (10) according to claim 12, wherein the antenna (600) is located on an inner wall of the first part (220a).

15. The electronic device (10) according to claim 12, when dependent on claim 2, wherein the antenna (600) is located at an end of the third part that is close to the first part (220a), and the radiator forms a part of the frame (220) or the antenna (600) is located on an inner wall of the third part.

## Patentansprüche

1. Elektronisches Gerät (10), umfassend:
eine Antenne (600),
einen Mittelrahmen (220), wobei der Mittelrahmen (220) einen Rahmen (220) und eine Mittelplatte (230) umfasst, die Mittelplatte (230) im Rahmen (220) befestigt ist, und die Mittelplatte (230) mit einem Verbindungsloch (234) versehen ist, wobei die Mittelplatte (230) einen ersten Bereich (235) aufweist, das Verbindungsloch (234) im ersten Bereich (235) angeordnet ist und der erste Bereich (235) sich auf der Mittelplatte (230) in einem Bereich von einem 1/4 einer Wellenlänge bis zu 3/4 einer Wellenlänge von der Antenne (600) befindet, wobei die Wellenlänge die Wellenlänge der Antenne (600) ist;
ein Anzeigemodul (100), wobei das Anzeigemodul (100) auf einer Seite der Mittelplatte (230) angeordnet und mit der Mittelplatte (230) gestapelt ist;
eine Leiterplatte, wobei die Leiterplatte auf einer Seite der Mittelplatte (230) angeordnet ist, die vom Anzeigemodul (100) abgewandt ist;
wobei die Antenne (600) am Mittelrahmen (220) angebracht ist; und
eine Verbindungsstruktur, wobei ein Ende der Verbindungsstruktur elektrisch mit der Leiterplatte verbunden ist und das andere Ende der Verbindungsstruktur durch das Verbindungsloch (234) hindurchgeführt und elektrisch mit dem Anzeigemodul (100) verbunden ist, wobei
ein vertikaler Projektionsbereich des Verbindungslochs (234) auf der Mittelplatte (230) in der Nähe eines Wellenknotens einer stehenden ten Welle der Antenne (600) angeordnet ist, wobei der Wellenknoten im ersten Bereich (235) liegt.

2. Elektronisches Gerät (10) nach Anspruch 1, wobei die Antenne (600) einen Strahler umfasst, der Strahler mit einem Speisepunkt und einem Massepunkt versehen ist, zwischen dem Speisepunkt und dem Massepunkt ein Referenzpunkt liegt und ein Bereich auf der Mittelplatte (230), der sich in einem Bereich von einem 1/4 einer Wellenlänge bis zu 3/4 einer Wellenlänge vom Referenzpunkt befindet, der erste Bereich (235) ist.

3. Elektronisches Gerät (10) nach Anspruch 1 oder 2, wobei die Antenne (600) eine GPS-Antenne (600) umfasst.

4. Elektronisches Gerät (10) nach einem der Ansprüche 1 bis 3, wobei von der Antenne (600) im elektronischen Gerät (10) ein elektromagnetisches Feld erzeugt wird, das einen schwachen Bereich aufweist, die Mittelplatte (230) einen zweiten Bereich (236) aufweist, der zweite Bereich (236) im schwachen Bereich angeordnet ist und das Verbindungsloch (234) im zweiten Bereich (236) liegt.

5. Elektronisches Gerät (10) nach Anspruch 4, wobei ein vertikaler Projektionsbereich der Verbindungsstruktur auf der Mittelplatte (230) einen Überlappungsbereich mit dem zweiten Bereich (236) aufweist und das Verbindungsloch (234) im Überlappungsbereich angeordnet ist.

6. Das elektronische Gerät (10) gemäß einem der Ansprüche 1 bis 5, wobei das elektronische Gerät (10) ferner umfasst:
eine Batterie (500), wobei sich die Batterie (500) auf der der Anzeigemodul (100) abgewandten Seite der Mittelplatte (230) befindet und das Verbindungsloch (234) sich in einem vertikalen Projektionsbereich der Batterie (500) auf der Mittelplatte (230) befindet.

7. Das elektronische Gerät (10) gemäß Anspruch 6, wobei der vertikale Projektionsbereich der Batterie (500) auf der Mittelplatte (230) keinen Überlappungsbereich mit dem vertikalen Projektionsbereich der Leiterplatte auf der Mittelplatte (230) aufweist.

8. Das elektronische Gerät (10) gemäß einem der Ansprüche 1 bis 7, wobei das Ende der Verbindungsstruktur elektrisch mit einer Seite der Leiterplatte verbunden ist, die der Mittelplatte (230) abgewandt ist.

9. Das elektronische Gerät (10) gemäß Anspruch 6 oder 7, wobei in Längsrichtung der Mittelplatte (230) die Batterie (500) mit einer der Leiterplatte nahen Kante versehen ist, ein Bereich auf der Mittelplatte (230), der sich von der Kante in einem Bereich von 1/8 Wellenlänge bis 5/8 Wellenlänge erstreckt, als erste Teilregion (235a) bezeichnet wird, und das Verbindungsloch (234) sich in der ersten Teilregion (235a) befindet.

10. Das elektronische Gerät (10) gemäß Anspruch 6 oder 7, wobei die erste Region (235) eine zweite Teilregion (235b) aufweist, sich das Verbindungsloch (234) in der zweiten Teilregion (235b) befindet und in einer zur Mittelplatte (230) parallelen Ebene der Abstand zwischen einer der Leiterplatte nahen Kante der zweiten Teilregion (235b) und einer der Leiterplatte nahen Kante der Batterie (500) L1 ergibt, wobei L1≥25 mm ist.

11. Das elektronische Gerät (10) gemäß Anspruch 10, wobei in der zur Mittelplatte (230) parallelen Ebene der Abstand zwischen einer der Leiterplatte abgewandten Kante der zweiten Teilregion (235b) und einer der Leiterplatte abgewandten Kante der Batterie (500) L2 ergibt, wobei L2≥15 mm ist.

12. Das elektronische Gerät (10) gemäß einem der Ansprüche 1 bis 11, wobei die Antenne (600) am Rahmen (220) angeordnet ist, der Rahmen (220) einen ersten Teil (220a), einen zweiten Teil (220b) und zwei dritte Teile umfasst, der erste Teil (220a) und der zweite Teil (220b) entlang der Längsrichtung auf zwei Seiten der Mittelplatte (230) verteilt sind, der erste Teil (220a) auf einer Oberseite der Mittelplatte (230) angeordnet ist und die beiden dritten Teile auf zwei Seiten der Mittelplatte (230) in Breitenrichtung angeordnet sind.

13. Das elektronische Gerät (10) gemäß Anspruch 12, in Abhängigkeit von Anspruch 2, wobei die Antenne (600) am ersten Teil (220a) angeordnet ist und der Strahler einen Teil des Rahmens (220) bildet.

14. Das elektronische Gerät (10) nach Anspruch 12, wobei sich die Antenne (600) an einer Innenwand des ersten Teils (220a) befindet.

15. Das elektronische Gerät (10) nach Anspruch 12, in Abhängigkeit von Anspruch 2, wobei sich die Antenne (600) an einem Ende des dritten Teils, das dem ersten Teil (220a) zugewandt ist, befindet und der Strahler einen Teil des Rahmens (220) bildet oder sich die Antenne (600) an einer Innenwand des dritten Teils befindet.

## Revendications

1. Un dispositif électronique (10), comprenant :
une antenne (600),
un cadre intermédiaire (220), le cadre intermédiaire (220) comprenant un châssis (220) et une plaque intermédiaire (230), la plaque intermédiaire (230) étant fixée dans le châssis (220), et la plaque intermédiaire (230) étant pourvue d'un trou de connexion (234), où la plaque intermédiaire (230) présente une première région (235), le trou de connexion (234) est situé dans la première région (235), et la première région (235) est une zone sur la plaque intermédiaire (230) comprise dans une plage allant d'un quart de longueur d'onde à trois quarts de longueur d'onde de l'antenne (600), où la longueur d'onde est celle de l'antenne (600) ;
un module d'affichage (100), le module d'affichage (100) étant situé d'un côté de la plaque intermédiaire (230) et empilé avec la plaque intermédiaire (230) ;
une carte de circuit imprimé, la carte de circuit étant disposée d'un côté de la plaque intermédiaire (230) opposé au module d'affichage (100) ;
l'antenne (600) étant placée sur le cadre intermédiaire (220) ; et
une structure de connexion, une extrémité de la structure de connexion étant reliée électriquement à la carte de circuit, et l'autre extrémité de la structure de connexion traversant le trou de connexion (234) et étant reliée électriquement au module d'affichage (100), dans lequel
une zone de projection verticale du trou de connexion (234) sur la plaque intermédiaire (230) est située à proximité d'un nœud d'onde d'une onde stationnaire de l'antenne (600), et le nœud d'onde est situé dans la première région (235).

2. Le dispositif électronique (10) selon la revendication 1, dans lequel l'antenne (600) comprend un radiateur, le radiateur comportant un point d'alimentation et un point de masse, un point de référence étant situé entre le point d'alimentation et le point de masse, et une zone sur la plaque intermédiaire (230) comprise dans une plage allant d'un quart de longueur d'onde à trois quarts de longueur d'onde à partir du point de référence constituant la première région (235).

3. Le dispositif électronique (10) selon la revendication 1 ou 2, dans lequel l'antenne (600) comprend une antenne GPS (600).

4. Le dispositif électronique (10) selon l'une des revendications 1 à 3, dans lequel un champ électromagnétique généré par l'antenne (600) dans le dispositif électronique (10) présente une zone faible, la plaque intermédiaire (230) présente une deuxième région (236), la deuxième région (236) étant située dans la zone faible, et le trou de connexion (234) étant situé dans la deuxième région (236).

5. Le dispositif électronique (10) selon la revendication 4, dans lequel une zone de projection verticale de la structure de connexion sur la plaque intermédiaire (230) présente une zone de chevauchement avec la deuxième région (236), et le trou de connexion (234) est situé dans la zone de chevauchement.

6. Le dispositif électronique (10) selon l'une quelconque des revendications 1 à 5, dans lequel le dispositif électronique (10) comprend en outre :
une batterie (500), la batterie (500) étant située du côté de la carte intermédiaire (230) opposé au module d'affichage (100), et l'orifice de connexion (234) étant situé dans une zone de projection verticale de la batterie (500) sur la carte intermédiaire (230).

7. Le dispositif électronique (10) selon la revendication 6, dans lequel la zone de projection verticale de la batterie (500) sur la carte intermédiaire (230) ne présente aucune région de chevauchement avec une zone de projection verticale de la carte de circuit imprimé sur la carte intermédiaire (230).

8. Le dispositif électronique (10) selon l'une quelconque des revendications 1 à 7, dans lequel l'extrémité de la structure de connexion est connectée électriquement à un côté de la carte de circuit imprimé opposé à la carte intermédiaire (230).

9. Le dispositif électronique (10) selon la revendication 6 ou 7, dans lequel, dans la direction de la longueur de la carte intermédiaire (230), la batterie (500) comporte une bordure proche de la carte de circuit imprimé, une zone sur la carte intermédiaire (230) qui se situe dans une plage allant d'1/8 de longueur d'onde à 5/8 de longueur d'onde depuis cette bordure constitue une première sous-région (235a), et l'orifice de connexion (234) est situé dans la première sous-région (235a).

10. Le dispositif électronique (10) selon la revendication 6 ou 7, dans lequel la première région (235) comprend une seconde sous-région (235b), l'orifice de connexion (234) est situé dans la seconde sous-région (235b), et, dans un plan parallèle à la carte intermédiaire (230), une distance entre une bordure de la seconde sous-région (235b) proche de la carte de circuit imprimé et une bordure de la batterie (500) proche de la carte de circuit imprimé est L1, où L1≥25 mm.

11. Le dispositif électronique (10) selon la revendication 10, dans lequel, dans le plan parallèle à la carte intermédiaire (230), une distance entre une bordure de la seconde sous-région (235b) éloignée de la carte de circuit imprimé et une bordure de la batterie (500) éloignée de la carte de circuit imprimé est L2, où L2≥15 mm.

12. Le dispositif électronique (10) selon l'une quelconque des revendications 1 à 11, dans lequel l'antenne (600) est située sur le cadre (220), le cadre (220) comprenant une première partie (220a), une seconde partie (220b) et deux troisièmes parties, la première partie (220a) et la seconde partie (220b) étant réparties sur les deux côtés de la carte intermédiaire (230) dans la direction de la longueur, la première partie (220a) étant disposée sur le côté supérieur de la carte intermédiaire (230), et les deux troisièmes parties étant disposées sur les deux côtés de la carte intermédiaire (230) dans la direction de la largeur.

13. Le dispositif électronique (10) selon la revendication 12, lorsqu'il dépend de la revendication 2, dans lequel l'antenne (600) est située sur la première partie (220a), et le radiateur forme une partie du cadre (220).

14. Le dispositif électronique (10) selon la revendication 12, dans lequel l'antenne (600) est située sur une paroi interne de la première partie (220a).

15. Le dispositif électronique (10) selon la revendication 12, dépendant de la revendication 2, dans lequel l'antenne (600) est située à une extrémité de la troisième partie proche de la première partie (220a), et le radiateur forme une partie du cadre (220) ou l'antenne (600) est située sur une paroi interne de la troisième partie.
